# EUROPEAN PATENT SPECIFICATION

(11) **EP 4 033 011 B1**
(45) Date of publication and mention of the grant of the patent: **05.11.2025**
(21) Application number: 20865135.6
(22) Date of filing: 07.09.2020
(51) Int. Cl.: C30B 25/14, C30B 29/06, C23C 16/455, C23C 16/52, C23C 16/24

(54) **EPITAXY APPARATUS AND GAS INLET STRUCTURE USED FOR EPITAXY APPARATUS**
EPITAXIEVORRICHTUNG UND GASEINLASSSTRUKTUR FÜR EPITAXIEVORRICHTUNG
APPAREIL D'ÉPITAXIE ET STRUCTURE D'ENTRÉE DE GAZ UTILISÉE POUR UN APPAREIL D'ÉPITAXIE

(30) Priority: 18.09.2019 CN 201910882912
(43) Date of publication of application: 27.07.2022
(73) Proprietor: Beijing NAURA Microelectronics Equipment Co., Ltd., Beijing 100176 (CN)
(72) Inventor: XIA, Zhenjun, Beijing 100176 (CN); WANG, Leilei, Beijing 100176 (CN)
(74) Representative: Cohausz & Florack
(86) International application number: PCT/CN2020/113708
(87) International publication number: WO 2021/052203

(56) References cited:
- WO-A1-2018/067191
- WO-A2-2013/016191
- CN-A- 104 756 231
- CN-A- 110 004 487
- CN-A- 111 455 458
- US-A1- 2011 114 013

## Description

### TECHNICAL FIELD

The present disclosure relates to the technical field of semiconductor technologies and, more particularly, to an epitaxial device and a gas intake structure for the epitaxial device.

### BACKGROUND

In a silicon epitaxy equipment, a uniform concentration of a process gas for an epitaxial reaction is usually introduced into a chamber from a gas intake, and the process gas flows horizontally across a surface of a wafer carried by a submount to grow an epitaxial layer, and then exits an exhaust gas outlet out of the chamber. Under the condition that a gas concentration and a gas temperature provided by a silicon source are fixed, a gas flow rate of the process gas is a main factor affecting film thickness distribution of the epitaxial layer. In order to ensure thickness uniformity of the epitaxial layer, it is necessary to make the submount rotatable. However, during simultaneous rotation of the wafer and the submount, an uncontrolled flow of the process gas may appear at the junction of the wafer and the submount, so that the thickness of the epitaxial layer at a peripheral edge of the wafer is extremely difficult to control, and it is difficult to ensure that the thickness distribution of the epitaxial layer is uniform.

D1(WO2018/067191A1) provides a flow ratio controller and a gas injection insert in a semiconductor processing chamber, and a first flow ratio controller, a second flow ratio controller and a gas injection insert are included. D2(WO2013/016191A2) provides an apparatus for deposition of materials on substrates, including a process chamber, a heating system, a gas inlet port, a first gas distribution conduit, and an exhaust manifold.

### SUMMARY

The present disclosure provides an epitaxial device and a gas intake structure for the epitaxial device to solve the technical problems described in the background section, e.g., a phenomenon of uneven thickness of an epitaxial layer at edges of a wafer.

One aspect of the present disclosure provides an epitaxial device. The epitaxial device, comprising:a chamber (4); a submount (5) disposed in the chamber (4) to carry a to-be-processed workpiece (6); a gas intake structure (1) disposed at a sidewall of the chamber (4) to provide a process gas to a to-be-processed surface of the to-be-processed workpiece (6), the gas intake structure (1) including: a plurality of first gas intake passages (2) configured to provide a first process gas to the entire to-be-processed surface along a first direction (X1), the first direction (X1) being parallel to the to-be-processed surface; and two second gas intake passages (3) that are arranged at intervals along a second direction (X2), and configured to provide a second process gas to two adjustment areas (61) adjacent to edges on both sides of the to-be-processed surface respectively along the first direction (X1), the plurality of first gas intake passage (2) being provided between the two second gas intake passages (3); and a total distribution distance of the two second gas intake passages (3) in the second direction (X2) is greater than a total distribution distance of the plurality of first gas intake passages (2) in the second direction (X2); each second gas intake passages (3) includes an auxiliary gas intake pipeline (31), and the auxiliary gas intake pipeline (31) has a plurality of outlets; or each second gas intake passages (3) includes a plurality of auxiliary gas intake pipelines (31), and each auxiliary gas intake pipeline (31) has a single outlet; and the second direction (X2) is perpendicular to the first direction (X1) and parallel to the to-be-processed surface; and an exhaust structure (7) arranged at a sidewall of the chamber (4) opposite to the gas intake structure (1), wherein the first process gas contains a gas for an epitaxial reaction, the second process gas does not contain the gas for the epitaxial reaction.

In some embodiments, the epitaxial device according to claim 1, wherein: a ratio of a radius of the to-be-processed surface over a width of each of the two adjustment areas (61) in the second direction (X2) is greater than or equal to about 15.

In some embodiments, the epitaxial device according to claim 1, wherein: a flow rate of the first process gas flowing out of the plurality of first gas intake passages (2) is a same as a flow rate of the second process gas flowing out of the two second gas intake passages (3).

In some embodiments, the epitaxial device according to claim 1, wherein: the plurality of first gas intake passages (2) is evenly arranged along the second direction (X2).

In some embodiments, the epitaxial device according to claim 1, wherein: a total distribution distance (Dg2) of the plurality of first gas intake passages (2) along the second direction (X2) is greater than or equal to a diameter (Ds) of the to-be-processed surface.

In some embodiments, the epitaxial device according to claim 1, wherein: when each second gas intake passage (3) includes a plurality of auxiliary gas intake pipelines (31) , and each auxiliary gas intake pipeline (31) has a single outlet; the plurality of auxiliary gas intake pipelines (31) is arranged in an equilateral polygon; and a lowest point of the equilateral polygon and a lowest point of the plurality of first gas intake passages (2) are in a same plane (P2).

In some embodiments, the epitaxial device according to claim 1, wherein: a ratio of a total distribution distance (Dg1) of the two second gas intake passages(3) along a second direction (X2) over a diameter (Ds) of the to-be-processed surface ranges between 0.8 and 1.4.

In some embodiments, the epitaxial device according to claim 1, wherein: each first gas intake passage (2) is spaced apart from an adjacent first gas intake passage (2) by a distance approximately between 5 mm and 30 mm.

In some embodiments, the epitaxial device according to claim 1, wherein: a ratio of a diameter of each first gas intake passage (2) over a diameter of each second gas intake passage (3) ranges between 60 and 6.

In some embodiments, the epitaxial device according to claim 1, wherein: the first process gas includes a carrier gas, the gas for the epitaxial reaction, and a dopant gas; the carrier gas includes at least one of nitrogen or hydrogen; the gas for the epitaxial reaction includes at least one of silane, silicon dichlorodihydrogen, silicon trichlorohydrogen, or silicon tetrachloride; and the dopant gas includes at least one of phosphine, diborane, or arsine.

In some embodiments, the epitaxial device according to claim 1, wherein: the second process gas includes a carrier gas; the carrier gas includes at least one of nitrogen or hydrogen.

Another aspect of the present disclosure provides a gas intake structure for an epitaxial device. The gas intake structure (1) for an epitaxial device, comprising: a plurality of first gas intake passages (2) configured to provide a first process gas to an entire to-be-processed surface along a first direction (X1), the first direction (X1) being parallel to the to-be-processed surface; and two second gas intake passages (3) that are arranged at intervals along a second direction (X2), and configured to provide a second process gas to two adjustment areas (61) adjacent to edges on both sides of the to-be-processed surface respectively along the first direction (X1), the plurality of first gas intake passage (2) being provided between the two second gas intake passages (3); and a total distribution distance (Dg1) of the two second gas intake passages (3) in the second direction (X2) is greater than a total distribution distance (Dg2) of the plurality of first gas intake passages (2) in the second direction (X2); each second gas intake passages (3) includes an auxiliary gas intake pipeline (31), and each the auxiliary gas intake pipeline (31) has a plurality of outlets; or each second gas intake passages (3) includes a plurality of auxiliary gas intake pipelines (31), and each auxiliary gas intake pipeline (31) has a single outlet; and the second direction (X2) is perpendicular to the first direction (X1) and parallel to the to-be-processed surface; and wherein the first process gas contains a gas for an epitaxial reaction, the second process gas does not contain the gas for the epitaxial reaction.

**In** some embodiments, the gas intake structure (1) according to claim 12, wherein: when each second gas intake passage (3) includes a plurality of auxiliary gas intake pipelines (31), and each auxiliary gas intake pipeline (31) has a single outlet; the plurality of auxiliary gas intake pipelines (31) is arranged in an equilateral polygon; and a lowest point of the equilateral polygon and a lowest point of the plurality of first gas intake passages (2) are in a same plane (P2).

**In** some embodiments, the gas intake structure (1) according to claim 13, wherein: each second gas intake passage (3) includes three auxiliary gas intake pipelines (31); and the three auxiliary gas intake pipelines (31) are arranged in an equilateral triangle.

**In** some embodiments, the gas intake structure (1) according to claim 12, wherein: a ratio of a diameter of each first gas intake passage (2) over a diameter of each second gas intake passage (3) ranges between 60 and 6.

The gas intake structure provided by the present disclosure includes the plurality of first gas intake passages and the two second gas intake passages, capable of providing the first process gas to the to-be-processed surface of the to-be-processed workpiece, and providing the second process gas to peripheral areas located on both sides of the to-be-processed surface. The second process gas is configured to adjust the concentration of the gas for the epitaxial reaction flowing through the adjustment areas, thereby improving the uniformity of the thickness distribution of the epitaxial layer formed on the entire to-be-processed surface. Because the first process gas and the second process gas enter in the same direction, the first process gas and the second process gas flow smoothly and no turbulence is generated, which is beneficial to control the thickness distribution of the epitaxial layer.

The epitaxial device provided by the embodiments of the present disclosure can improve the uniformity of the thickness distribution of the epitaxial layer formed on the entire to-be-processed surface by adopting the gas intake structure provided by the embodiments of the present disclosure.

### BRIEF DESCRIPTION OF THE DRAWINGS

FIG. 1 is a schematic top view of an epitaxy device according to some embodiments of the present disclosure;
FIG. 2 is a schematic side view of an epitaxy device according to some embodiments of the present disclosure;
FIG. 3 is a schematic diagram of a gas intake structure according to some embodiments of the present disclosure;
FIG. 4 is a schematic diagram of another gas intake structure according to some embodiments of the present disclosure;
FIG. 5 is a schematic top view of another epitaxy device according to some embodiments of the present disclosure; and
FIG. 6 is a flowchart of a gas intake method according to some embodiments of the present disclosure.

### DETAILED DESCRIPTION OF THE EMBODIMENTS

Various embodiments or examples are provided to illustrate various features of the present disclosure. Specific examples of components and configurations are described below to simplify the present disclosure. As can be appreciated, descriptions are intended to be exemplary, and not to limit the present disclosure. For example, in the description below, forming a first feature on or over a second feature may include some embodiments in which the first feature and the second feature directly contact with each other, and some embodiments in which additional components are formed between the first feature and the second feature, such that the first feature and the second feature do not directly contact with each other. Further, the present disclosure may reuse reference symbols and/or numerals in various embodiments. Such reuse is for brevity and clarity, and does not in itself represent a relationship between different embodiments and/or configurations discussed.

Further, spatial relationship terms, such as "below," "under," "lower," "above," "over," and the like, may be used to facilitate description of relationship of one component or feature with respect to another component or feature as shown in drawings. These spatial relationship terms are intended to encompass many different orientations of a device in user or operation in addition to orientations depicted in the drawings. The device may be positioned in other orientations (e.g., rotated 90 degrees or at other orientations) and these spatial relationship terms should be interpreted accordingly.

Although numerical ranges and parameters used to set forth a broader scope of the application are approximate values, numerical values set forth in specific examples have been reported as precisely as possible. Any such numerical value, however, inherently contains standard deviations resulting from individual testing methods. As used herein, the term "about" generally refers to that an actual value is within plus or minus 10%, 5%, 1%, or 0.5% of a particular value or range. Alternatively, the word "about" refers to that the actual value lies within an acceptable standard deviation of a mean, as considered by one of ordinary skill in the art to which this application pertains. It should be understood that, except in experimental examples, unless otherwise expressly stated, all ranges, quantities, numerical values and percentages used herein (e.g., describe amount of material, length of time, temperature, operating condition, quantity ratio, and the like) are modified by "about". Thus, unless otherwise stated to the contrary, the numerical parameters disclosed in this specification and accompanying claims are approximate numerical values and may be changed as required. At a minimum, these numerical parameters should be construed to refer to a number of significant digits as indicated and the numerical values obtained by applying ordinary rounding. The numerical ranges are expressed herein as from one endpoint to another endpoint or between two endpoints. Unless otherwise indicated, the numerical ranges recited herein are inclusive of the endpoints.

In the existing technology, to improve uniformity of thickness distribution of the epitaxial layer, a chamber assembly of a silicon epitaxy device includes a main gas intake structure and an auxiliary gas intake structure for introducing a main process gas and an auxiliary process gas into the chamber from different directions. However, after the main process gas and the auxiliary process gas enter the chamber, flows of the main process gas and the auxiliary process gas are disturbed when the main process gas and the auxiliary process gas intersect with each other. As a result, it is difficult to control the thickness distribution of the formed epitaxial layer.

The present disclosure is made in consideration of the above-mentioned circumstances, and provides a thin film forming method and an epitaxial device using an epitaxial process, which can achieve a stable epitaxial layer growth rate while ensuring a uniform thickness distribution of the epitaxial layer. Further, the present disclosure provides a chamber assembly for the epitaxial device, which includes a gas intake structure. In some embodiments, the gas intake structure includes a plurality of first gas intake passages and two second gas intake passages. The two second gas intake passages are arranged at intervals along a second direction, respectively corresponding to two adjustment areas adjacent to edges of both sides of a to-be-processed surface. At least one first gas intake passage is disposed between the two second gas intake passages. Each second gas intake passage is configured to provide a second process gas to the adjustment area along a first direction. These component improvements improve the uniformity of the thickness distribution of the epitaxial layer formed on the to-be-processed surface, thereby improving product quality.

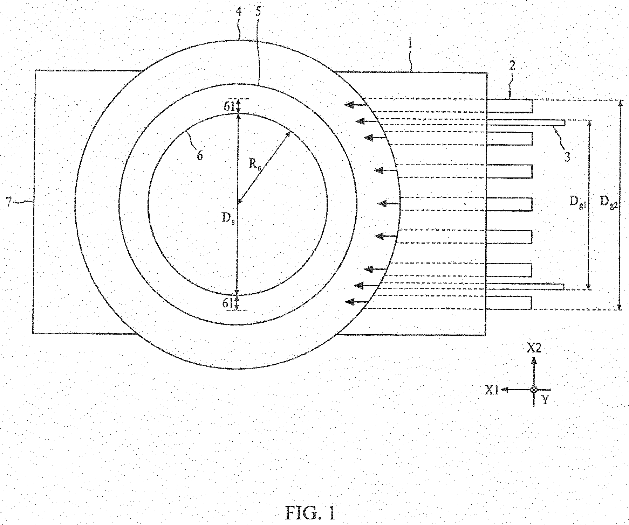

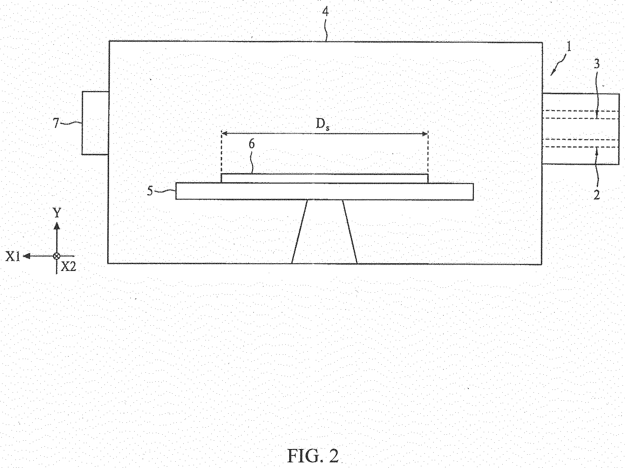

FIG. 1 and FIG. 2 are schematic diagrams of an epitaxial device according to some embodiments of the present disclosure. In some embodiments, the epitaxial device is configured to process the to-be-processed surface of a to-be-processed workpiece, for example, to form an epitaxial layer on the to-be-processed surface of the to-be-processed workpiece (e.g., a wafer). As shown in FIG. 1 and FIG. 2, the epitaxial device includes a chamber 4, a submount 5 disposed in the chamber 4 for carrying a workpiece 6, a gas intake structure 1, and an exhaust structure 7. The gas intake structure 1 is disposed at a sidewall of the chamber 4 and is configured to provide a process gas to the to-be-processed surface of the to-be-processed workpiece 6. The exhaust structure 7 is disposed at a sidewall of the chamber 4 opposite to the gas intake structure 1 for discharging the process gas.

In some embodiments, as shown in FIG. 1, when being viewed from the above, a diameter of an upper surface of the submount 5 is greater than a diameter of a to-be-processed surface of the to-be-processed workpiece 6, such that when the to-be-processed workpiece 6 is placed on the upper surface of the submount 5, a portion of the upper surface of the submount 5 (i.e., an area located outside the to-be-processed workpiece 6) is not covered by the to-be-processed workpiece 6. In some embodiments, the submount 5 can be rotated. When the submount 5 rotates, the to-be-processed workpiece 6 rotates jointly. In some embodiments, the submount 5 may heat the to-be-processed workpiece 6, such that an epitaxial layer may be formed on the to-be-processed workpiece 6 at a pre-determined temperature.

The gas intake structure 1 includes a plurality of first gas intake passages 2 and two second gas intake passages 3. The plurality of first gas intake 2 are configured to provide a first process gas to the to-be-processed surface of the to-be-processed workpiece 6 along a first direction X1. The first process gas contains a gas configured for epitaxial reaction. The first direction X1 is parallel to the to-be-processed surface of the to-be-processed workpiece 6. Specifically, the first direction X1 is one of radial directions parallel to the to-be-processed surface. The two second gas intake passages 3 are arranged at intervals along a second direction X2, and at least one first gas intake passage 2 is disposed between the two second gas intake passages 3. The second direction X2 is parallel to the to-be-processed surface of the to-be-processed workpiece 6, and is perpendicular to the first direction X1. **In** addition, the two second gas intake passages 3 respectively correspond to two adjustment areas 61 adjacent to edges of both sides of the to-be-processed surface. Each second gas intake passage 3 is configured to provide a second process gas to one of the two adjustment areas 61 along the first direction X1. The second process gas is configured to adjust concentration of the gas that flows through each of the two adjustment areas for the epitaxial reaction.

In practical applications, the first process gas and the second process gas can be introduced into the chamber 4 simultaneously or alternately by using the above-described gas intake structure 1. When the first process gas and the second process gas are introduced into the chamber 4 simultaneously, the first process gas and the second process gas enter the plurality of first gas intake passages 2 and the two second gas intake passages 3 along the first direction X1, that is, the first process gas and the second process gas enter in the same direction. After the first process gas and the second process gas respectively pass over the to-be-processed surface and the adjustment areas 61 along the first direction X1, the first process gas and the second process gas continue to enter the exhaust structure 7 along the first direction X1, such that the no turbulence occurs. In addition to passing the first process gas, the concentration of the gas that flows through each of the two adjustment areas 61 for the epitaxial reaction may be adjusted by passing the second process gas into each of the two adjustment areas 61. Thus, difference in the concentration of the gas for the epitaxial reaction between the edges adjacent to the adjustment areas 61 and a center area of the to-be-processed surface is reduced.

For example, when the epitaxial device is configured to process the to-be-processed surface of the to-be-processed workpiece 6, the submount 5 drives the to-be-processed workpiece 6 to rotate jointly. An abrupt flow rate change of the gas that flows through the adjustment areas 61 located on both sides of the to-be-processed surface of the to-be-processed workpiece 6 may occur. This makes the thickness of the epitaxial layer formed in the center area of the to-be-processed surface different from the thickness of the epitaxial layer formed in the edges adjacent to the adjustment areas 61. Specifically, the thickness of the epitaxial layer formed in the edges of the to-be-processed surface is thicker than the thickness of the epitaxial layer formed in the center area of the to-be-processed surface. In this case, the concentration of the gas that flows through the adjustment areas 61 for the epitaxial reaction may be diluted by the second process gas, such that the thickness of the epitaxial layer formed in the edges of the to-be-processed surface becomes thinner. Thus, the distribution uniformity of the thickness of the epitaxial layer formed on the to-be-processed surface is improved.

In some embodiments, the second process gas contains the gas for the epitaxial reaction, and a content of the gas for the epitaxial rection in the second process gas is lower than the content of the gas for the epitaxial reaction in the first process gas. In this way, the second process gas functions to dilute the concentration of the gas that flows through the adjustment areas 61 for the epitaxial reaction. In practical applications, the second process gas may not contain the gas for the epitaxial reaction, and can be any gas that can adjust the concentration of the gas that flows through the adjustment areas 61 for the epitaxial reaction.

In some embodiments, the second process gas is further configured to form a gas curtain at the adjustment areas 61 located on both sides of the to-be-processed surface to ensure that the first process gas flows over the to-be-processed surface.

It should be noted that, as shown in FIG. 1, the adjustment areas 61 are located outside the edges of the to-be-processed surface. However, the present disclosure is not limited by the arrangement shown in FIG. 1. In practical applications, a range of the adjustment areas 61 has no particular restriction. For example, the adjustment areas 61 may be located inside the edges of the to-be-processed surface, or may be located both outside and inside the edges of the to-be-processed surface.

In some embodiments, a ratio of a radius Rs of the to-be-processed surface over a width of each of the two adjustment areas 61 in the second direction is greater than or equal to about 15.

In some embodiments, a flow rate of the first process gas that flows out of the first gas intake passages 2 is a same as a flow rate of the second process gas that flows out of the second gas intake passages 3. In this way, in addition to making the first process gas and the second process gas flow along the first direction X1, by making the flow rate of the first process gas that flows out of the first gas intake passages 2 the same as the flow rate of the second process gas that flows out of the second gas intake passages 3, the gas flows over the entire to-be-processed surface smoothly without any turbulence, thereby forming the epitaxial layer with a uniform thickness on the entire to-be-processed surface.

In some embodiments, the plurality of first gas intake passages 2 are evenly arranged along the second direction X2. In this way, in addition to making the first process gas out of each first gas intake passage 2 flow along the first direction X1, the plurality of first gas intake passages 2 are evenly arranged along the second direction X2, such that the first process gas that flows through different positions on the to-be-processed surface can be evenly distributed. Arrangement density of the plurality of first gas intake passages 2 may be flexibly adjusted according to specific requirements. For example, the arrangement density of the plurality of first gas intake passages may be adjusted according to parameters, such as a size of the to-be-processed workpiece 6, a spatial dimension of the chamber 4, a flow rate of the gas, etc.

In some embodiments, each first gas intake passage 2 is separated from adjacent first gas intake passages 2 by a distance approximately between 5 mm and 30 mm.

In some embodiments, a total distribution distance Dg2 of the plurality of first gas intake passages 2 arranged along the second direction X2 is greater than or equal to a diameter Ds of the to-be-processed surface, such that the first process gas out of the plurality of fist gas intake passages 2 can flow over the entire to-be-processed surface. The total distribution distance Dg2 refers to a maximum distance in the second direction X2 between two outermost first gas intake passages 2.

In some embodiments, a distance in a third direction Y between the gas intake structure 1 and the to-be-processed surface is not limited by the present disclosure, as long as the first process gas can effectively react with the entire to-be-processed surface. The third direction Y is perpendicular to the to-be-processed surface.

In some embodiments, a center of each first gas intake passage 2 and a center of each second gas intake passage 3 are at the same distance from the to-be-processed surface in the third direction Y, that is, each first gas intake passage 2 and each second gas intake passage 3 are located at a same height relative to the to-be-processed surface.

In some embodiments, the first process gas includes a carrier gas, a gas for the epitaxial reaction, and a dopant gas. The carrier gas includes at least one of nitrogen (N₂) or hydrogen (H₂). The gas for the epitaxial reaction includes at least one of silane (SiH₄), silicon dichlorodihydrogen (SiH₂Cl₂), silicon trichlorohydrogen (SiHCl₃), or silicon tetrachloride (SiCl₄). The dopant gas includes at least one of phosphine (PH₃), diborane (B₂H₆), or arsine (AsH₃).

In some embodiments, the second process gas includes at least one of the carrier gas, the gas for the epitaxial reaction, or the dopant gas. The content of the gas for the epitaxial reaction in the second process gas is lower than the content of the gas for the epitaxial reaction in the first process gas. The carrier gas includes at least one of nitrogen (N₂) or hydrogen (H₂). The gas for the epitaxial reaction includes at least one of silane (SiH₄), silicon dichlorodihydrogen (SiH₂Cl₂), silicon trichlorohydrogen (SiHCl₃), or silicon tetrachloride (SiCl₄). The dopant gas includes at least one of phosphine (PH₃), diborane (B₂H₆), or arsine (AsH₃).

The second process gas is configured to adjust the concentration of the gas for the epitaxial reaction in the adjustment areas 61. For example, the second process gas may dilute the gas for the epitaxial reaction in the adjustment areas 61, such that the concentration of the gas for the epitaxial rection in the adjustment areas 61 is reduced. In some embodiments, under conditions that a composition and a flow rate of the first process gas are fixed, by adjusting the carrier gas concentration of the second process gas and the position of each second gas intake passages 3, the concentration of the gas for the epitaxial reaction and a dilution area can be changed.

In some embodiments, if the gas for the epitaxial reaction in the adjustment areas 61 needs to be diluted, each second gas intake passage 3 can be configured to provide a stable flow of the second process gas to the corresponding adjustment area 61. For example, the flow rate of the second process gas that flows out of each second gas intake passage 3 is fixed.

In some embodiments, with different process conditions, the first process gas can be appropriately diluted by adjusting the carrier gas concentration in the second process gas when the flow rate of the second process gas is fixed. In some embodiments, the carrier gas of the second process gas is configured to dilute the gas for the epitaxial reaction in the first process gas. In some embodiments, to prevent the concentration of the gas for the epitaxial reaction in the first process gas from suddenly dropping too low in the diluted area, it should be ensured that proportions of the carrier gas contained in the second process gas and the gas for epitaxial reaction are appropriate. In some embodiments, the second process gas includes the carrier gas and the dopant gas, but does not include the gas for the epitaxial reaction.

In some embodiments, in the first process gas, the proportion of the gas for the epitaxial reaction is a%, and the proportion of the carrier gas is (100-a)% (the dopant gas is additionally counted). In the second process gas, the proportion of the gas for the epitaxial reaction is b%, and the proportion of the carrier gas is (100-b)% (the dopant gas is additionally counted). a and b are positive numbers. a is smaller than 100 and is greater than b. As such, when the first process gas with the content m is mixed with the second process gas with the content n, assuming that the concentration of the mixed gas for the epitaxial reaction is x%, then x% is equal to (*am* + *bn*)/(*m + n*), and x is between a and b. It can be seen from the foregoing description that when the content of the gas for the epitaxial reaction in the second process gas is lower than the content of the gas for the epitaxial reaction in the first process gas, the second process gas dilutes the gas for the epitaxial reaction in the first process gas, thereby improving the thickness uniformity of the epitaxial layer formed across the to-be-processed surface.

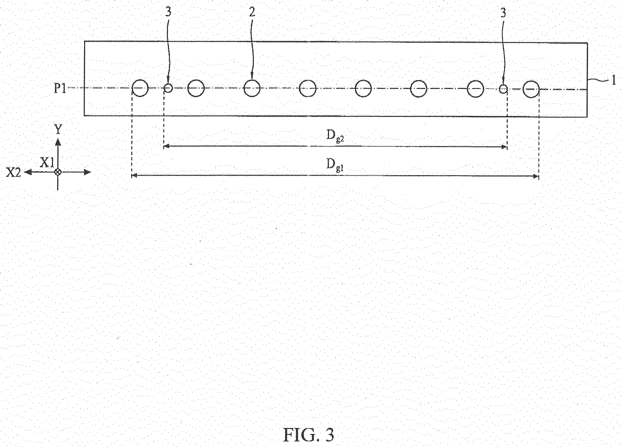

FIG. 3 is a schematic diagram of a gas intake structure according to some embodiments of the present disclosure. In some embodiments, as shown in FIG. 3, a diameter of each second gas intake passage 3 is smaller than a diameter of each first gas intake passage 2, such that a width of the distribution area of the second process gas flowing out of the second gas intake passages 3 is relatively narrow in the second direction X2, and does not occupy the distribution area of the first process gas flowing out of the first gas intake passages 2, thereby ensuring that the first process gas performs the epitaxial reaction with the to-be-processed surface. In some embodiments, a ratio of the diameter of each first gas intake passage 2 over the diameter of each second gas intake passage 3 ranges between 60 and 6.

In some embodiments, the center of an outlet of each first gas intake passage 2 and the center of an outlet of each second gas intake passage 3 are located on a same plane. For example, the center of the outlet of each first gas intake passage 2 and the center of the outlet of each second gas intake passage 3 are located on a plane P1. The plane P1 is parallel to the to-be-processed surface. In some embodiments, the ratio of the total distribution distance Dg1 of the two second gas intake passages 3 in the second direction X2 over the diameter Ds of the to-be-processed surface ranges between 0.8 and 1.4. The total distribution distance Dg1 refers to the maximum distance in the second direction X2 between the two outermost second gas intake passage 3.

In some embodiments, the total distribution distance Dg1 of the two second gas intake passages 3 in the second direction X2 is equal to *Ds* ± 50*mm*, where Ds is the diameter of the to-be-processed surface. In some embodiments, the total distribution distance Dg1 of the two second gas intake passages 3 in the second direction X2 is smaller than the total distribution distance Dg2 of the plurality of first gas intake passages 2 in the second direction X2.

It should be noted that, in the embodiment shown in FIG. 3, each first gas intake passage 2 and each second gas intake passage 3 may be respectively connected with independent pipelines, and each independent pipeline independently provides the first process gas to the corresponding first gas intake passage 2 or provides the second process gas to the corresponding second gas intake passage 3. However, this is not a limitation of the embodiments of the present disclosure. In some other embodiments, the plurality of first gas intake passages 2 may be connected to a same pipeline, which simultaneously provides the first process gas to each first gas intake passage 2. The two second gas intake passages 3 may be connected to another same pipeline, which simultaneously provides the second process gas to each second gas intake passage 3. As long as the flow rates of the first process gas and the second process gas flowing out of the outlets of each of the plurality of first gas intake passages 2 and each of the two second gas intake passage 3 are the same, the pipeline configurations fall within the scope of the embodiments of the present disclosure.

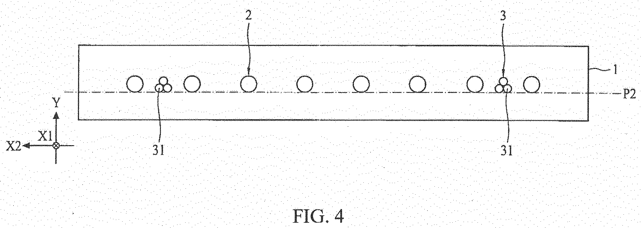

FIG. 4 is a schematic diagram of another gas intake structure according to some embodiments of the present disclosure. In some embodiments, as shown in FIG. 4, dispersing the flow of the second process gas is beneficial to keep the flow of the first process gas smooth. For example, but not limited to, each second gas intake passage 3 has a plurality of outlets, each second gas intake passage 3 includes an auxiliary gas intake pipeline, and the auxiliary gas intake pipeline has a plurality of outlets. Alternatively, each second gas intake passage 3 includes a plurality of auxiliary gas intake pipelines, and each auxiliary gas intake pipeline has a single outlet. For example, as shown in FIG. 4, each second gas intake passage 3 includes three auxiliary gas intake pipelines 31. Each auxiliary gas intake pipeline 31 has a single outlet. As long as the second process gas flows out of each outlet at the same flow rate, these embodiments fall within the scope of the present disclosure.

In some embodiments, the plurality of auxiliary gas intake pipelines is arranged to form a shape corresponding to a radial cross-sectional shape of an equilateral polygon, such as, but not limited to, an equilateral triangle, and one side of the equilateral polygon and the lowest point of the radial cross-section of the plurality of first gas intake passages 2 are located at a same plane. For example, one side of the equilateral polygon and the lowest point of the radial cross-section of the plurality of first gas intake passages 2 are located at the same plane P2. For example, as shown in FIG. 4, the three auxiliary gas intake pipelines 31 are arranged to form the shape of the radial cross-section in an equilateral triangle. The base side of the equilateral triangle is located at, for example, but not limited to, the same plane P2 as the lowest point of the radial cross-section of the plurality of first gas intake passages 2.

In practical applications, the epitaxial device may also have other devices or components to process the to-be-processed workpiece 6. For example, the epitaxial device may include a heating device for adjusting a temperature of the to-be-processed workpiece 6 carried on the submount 5 to a pre-determined process temperature. For example, the heating device is disposed in the submount 5. For brevity of drawings, FIG. 1 and FIG. 2 only depict devices and components related to the description of the embodiments of the present disclosure.

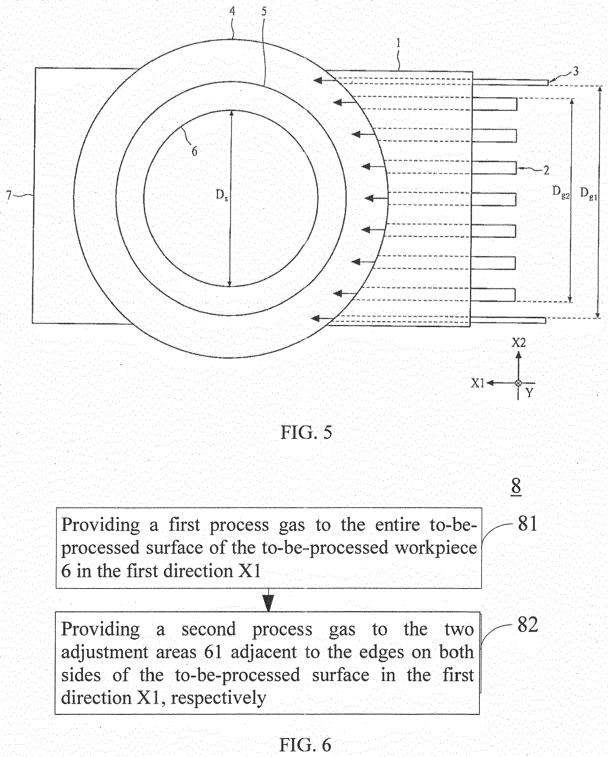

FIG. 5 is a schematic top view of another epitaxy device according to some embodiments of the present disclosure. In some embodiments, as shown in FIG. 5, the total distribution distance Dg1 of the two second gas intake passages 3 in the second direction X2 is greater than the total distribution distance Dg2 of the plurality of first gas intake passages 2 in the second direction X2. In other words, as shown in FIG. 5, when the gas intake structure 1 is viewed in a top-down view, the plurality of first gas intake passages 2 is disposed between the two second gas intake passages 3. In this case, the first process gas provided by the gas intake structure 1 is all confined between the gas curtains formed by the second process gas on both sides of the to-be-processed surface. In some embodiments, the total distribution distance Dg1 of the two second gas intake passages 3 in the second direction X2 is greater than the diameter Ds of the to-be-processed surface. In some embodiments, the total distribution distance Dg1 of the two second gas intake passages 3 in the second direction X2 is greater than the total distribution distance Dg2 of the plurality of first gas intake passages 2 in the second direction X2, and the total distribution distance Dg2 of the plurality of first gas intake passages 2 in the second direction X2 is greater than the diameter Ds of the to-be-processed surface.

The present disclosure also provides a gas intake method, especially a gas intake method for an epitaxial device. FIG. 6 is a flowchart of a gas intake method according to some embodiments of the present disclosure. Steps shown in Fig. 6 need not be performed in an order as described, and may be performed in other others or concurrently, provided that substantially same results can be obtained. The gas intake method 8 includes the following steps.

At step 81, a first process gas is provided to the entire to-be-processed surface of the to-be-processed workpiece 6 in the first direction X1.

At step 82, a second process gas is provided to the two adjustment areas 61 adjacent to the edges on both sides of the to-be-processed surface in the first direction X1, respectively. In some embodiments, the gas intake method 8 is performed in the epitaxial device as shown in FIG. 1, FIG. 2, or FIG. 5.

In some embodiments, the first process gas and the second process gas are provided at the same time. The second process gas is configured to adjust the concentration of the gas for the epitaxial reaction flowing through the adjustment areas 61, for example, to dilute the gas for the epitaxial reaction in the first process gas.

In some embodiments, the first direction X1 is parallel to a radial direction of the to-be-processed surface, and is located above the to-be-processed surface. The first process gas and the second process gas are able to cause the epitaxial reaction to the to-be-processed surface. In some embodiments, to keep the overall gas to smoothly flow in the chamber 1, the flow rate of the first process gas flowing through the to-be-processed surface is the same as the flow rate of the second process gas flowing through the adjustment areas 61.

The present disclosure is further described with respect to the following embodiments. But it should be understood that these embodiments are only intended to be illustrative and should not be construed as a limitation of the present disclosure.

### Embodiment 1

The first process gas is introduced into the chamber 4 through the plurality of first gas intake passages 2 along the first direction X1 to cause the epitaxial reaction of the first process gas with the to-be-processed surface of the to-be-processed workpiece 6 carried by the submount 5 in the chamber 4. The flow rate of the first process gas is about 50 standard liter per minute (SLM). The concentration of the gas for the epitaxial reaction contained in the first process gas is about 4%. At the same time, the second process that does not contain the gas for the epitaxial reaction is introduced into the chamber 4 through the two second gas intake passages 3 along the first direction X1 to provide the second process gas to the adjustment area 61 on both sides of the to-be-processed surface. The flow rate of the second process gas is about 3 SLM.

The gas for the epitaxial reaction includes a silicon source.

The to-be-processed workpiece 6 is a wafer. The average concentration of the gas for the epitaxial reaction flowing through the adjustment area 61 is about 3.5%. After epitaxial growth, the thickness of the epitaxial layer at a distance 3 mm from the edge of the epitaxial layer is about 1% thicker than the thickness of the epitaxial layer at a distance 10 mm from the edge of the epitaxial layer.

### Comparative example 1

The first process gas is introduced into the chamber 4 through the plurality of first gas intake passages 2 along the first direction X1 to cause the epitaxial reaction of the first process gas with the to-be-processed surface of the to-be-processed workpiece 6 carried by the submount 5 in the chamber 4. The flow rate of the first process gas is about 50 standard liter per minute (SLM). The concentration of the gas for the epitaxial reaction contained in the first process gas is about 4%. At the same time, no gas is introduced into the chamber 4 through the two second gas intake passages 3. The gas for the epitaxial reaction includes a silicon source.

The to-be-processed workpiece 6 is a wafer. After the epitaxial growth, the thickness of the epitaxial layer at a distance 3 mm from the edge of the epitaxial layer is about 4% thicker than the thickness of the epitaxial layer at a distance 10 mm from the edge of the epitaxial layer.

By comparing the embodiments 1 and the comparative example 1, it can be seen that while the first process gas is introduced through the plurality of first gas intake passages 2, the second process gas that contains or does not contain the gas for the epitaxial reaction is introduced through the two second gas intake passages 3, thereby improving the distribution uniformity of the thickness of the epitaxial layer formed on the entire to-be-processed surface of the to-be-processed workpiece 6.

The embodiments of the present disclosure provide the gas intake structure and the related epitaxial device. The gas intake structure provided by the present disclosure includes the plurality of first gas intake passages 2 and the two second gas intake passages 3. The plurality of first gas intake passages 2 provides the first process gas to the to-be-processed surface of the to-be-processed workpiece 6. The two second gas intake passages 3 provides the second process gas to peripheral areas located on both sides of the to-be-processed surface in the same direction as the plurality of first gas intake passages. The first process gas contains the gas for the epitaxial reaction. The second process gas contains or does not contain the gas for the epitaxial reaction. The content of the gas for the epitaxial reaction in the second process gas is lower than the content of the gas for the epitaxial reaction in the first process gas. The gas intake structure provided by the embodiments of the present disclosure makes the first process gas and the second process gas flow smoothly, thereby improving the uniformity of the thickness distribution of the epitaxial layer formed on the entire to-be-processed surface.

## Claims

1. An epitaxial device, comprising:
a chamber (4);
a submount (5) disposed in the chamber (4) to carry a to-be-processed workpiece (6);
a gas intake structure (1) disposed at a sidewall of the chamber (4) to provide a process gas to a to-be-processed surface of the to-be-processed workpiece (6), the gas intake structure (1) including:
a plurality of first gas intake passages (2) configured to provide a first process gas to the entire to-be-processed surface along a first direction (X1), the first direction (X1) being parallel to the to-be-processed surface; and
two second gas intake passages (3) that are arranged at intervals along a second direction (X2), and configured to provide a second process gas to two adjustment areas (61) adjacent to edges on both sides of the to-be-processed surface respectively along the first direction (X1), the plurality of first gas intake passage (2) being provided between the two second gas intake passages (3); and a total distribution distance of the two second gas intake passages (3) in the second direction (X2) is greater than a total distribution distance of the plurality of first gas intake passages (2) in the second direction (X2);
each second gas intake passages (3) includes an auxiliary gas intake pipeline (31), and the auxiliary gas intake pipeline (31) has a plurality of outlets; or each second gas intake passages (3) includes a plurality of auxiliary gas intake pipelines (31), and each auxiliary gas intake pipeline (31) has a single outlet; and
the second direction (X2) is perpendicular to the first direction (X1) and parallel to the to-be-processed surface; and
an exhaust structure (7) arranged at a sidewall of the chamber (4) opposite to the gas intake structure (1),
wherein the first process gas contains a gas for an epitaxial reaction, the second process gas does not contain the gas for the epitaxial reaction.

2. The epitaxial device according to claim 1, wherein:
a ratio of a radius of the to-be-processed surface over a width of each of the two adjustment areas (61) in the second direction (X2) is greater than or equal to about 15.

3. The epitaxial device according to claim 1, wherein:
a flow rate of the first process gas flowing out of the plurality of first gas intake passages (2) is a same as a flow rate of the second process gas flowing out of the two second gas intake passages (3).

4. The epitaxial device according to claim 1, wherein:
the plurality of first gas intake passages (2) is evenly arranged along the second direction (X2).

5. The epitaxial device according to claim 1, wherein:
a total distribution distance (Dg2) of the plurality of first gas intake passages (2) along the second direction (X2) is greater than or equal to a diameter (Ds) of the to-be-processed surface.

6. The epitaxial device according to claim 1, wherein:
when each second gas intake passage (3) includes a plurality of auxiliary gas intake pipelines (31), and each auxiliary gas intake pipeline (31) has a single outlet;
the plurality of auxiliary gas intake pipelines (31) is arranged in an equilateral polygon; and
a lowest point of the equilateral polygon and a lowest point of the plurality of first gas intake passages (2) are in a same plane (P2).

7. The epitaxial device according to claim 1, wherein:
a ratio of a total distribution distance (Dg1) of the two second gas intake passages (3) along a second direction (X2) over a diameter (Ds) of the to-be-processed surface ranges between 0.8 and 1.4.

8. The epitaxial device according to claim 1, wherein:
each first gas intake passage (2) is spaced apart from an adjacent first gas intake passage (2) by a distance approximately between 5 mm and 30 mm.

9. The epitaxial device according to claim 1, wherein:
a ratio of a diameter of each first gas intake passage (2) over a diameter of each second gas intake passage (3) ranges between 60 and 6.

10. The epitaxial device according to claim 1, wherein:
the first process gas includes a carrier gas, the gas for the epitaxial reaction, and a dopant gas;
the carrier gas includes at least one of nitrogen or hydrogen;
the gas for the epitaxial reaction includes at least one of silane, silicon dichlorodihydrogen, silicon trichlorohydrogen, or silicon tetrachloride; and
the dopant gas includes at least one of phosphine, diborane, or arsine.

11. The epitaxial device according to claim 1, wherein:
the second process gas includes a carrier gas;
the carrier gas includes at least one of nitrogen or hydrogen.

12. A gas intake structure (1) for an epitaxial device, comprising:
a plurality of first gas intake passages (2) configured to provide a first process gas to an entire to-be-processed surface along a first direction (X1), the first direction (X1) being parallel to the to-be-processed surface; and
two second gas intake passages (3) that are arranged at intervals along a second direction (X2), and configured to provide a second process gas to two adjustment areas (61) adjacent to edges on both sides of the to-be-processed surface respectively along the first direction (X1), the plurality of first gas intake passage (2) being provided between the two second gas intake passages (3); and a total distribution distance (Dg1) of the two second gas intake passages (3) in the second direction (X2) is greater than a total distribution distance (Dg2) of the plurality of first gas intake passages (2) in the second direction (X2);
each second gas intake passages (3) includes an auxiliary gas intake pipeline (31), and the auxiliary gas intake pipeline (31) has a plurality of outlets; or each second gas intake passages (3) includes a plurality of auxiliary gas intake pipelines (31), and each auxiliary gas intake pipeline (31) has a single outlet; and
the second direction (X2) is perpendicular to the first direction (X1) and parallel to the to-be-processed surface; and
wherein the first process gas contains a gas for an epitaxial reaction, the second process gas does not contain the gas for the epitaxial reaction.

13. The gas intake structure (1) according to claim 12, wherein:
when each second gas intake passage (3) includes a plurality of auxiliary gas intake pipelines (31), and each auxiliary gas intake pipeline (31) has a single outlet;
the plurality of auxiliary gas intake pipelines (31) is arranged in an equilateral polygon; and
a lowest point of the equilateral polygon and a lowest point of the plurality of first gas intake passages (2) are in a same plane (P2).

14. The gas intake structure (1) according to claim 13, wherein:
each second gas intake passage (3) includes three auxiliary gas intake pipelines (31); and
the three auxiliary gas intake pipelines (31) are arranged in an equilateral triangle.

15. The gas intake structure (1) according to claim 12, wherein:
a ratio of a diameter of each first gas intake passage (2) over a diameter of each second gas intake passage (3) ranges between 60 and 6.

## Patentansprüche

1. Epitaxievorrichtung, aufweisend:
eine Kammer (4);
eine Sub-Halterung (5), die in der Kammer (4) angeordnet ist, um ein zu bearbeitendes Werkstücks (6) zu tragen;
eine Gaseinlassstruktur (1), die an einer Seitenwand der Kammer (4) angeordnet ist, um ein Prozessgas für eine zu bearbeitende Fläche des zu bearbeitenden Werkstücks (6) vorzusehen, wobei die Gaseinlassstruktur (1) aufweist:
mehrere erste Gaseinlasskanäle (2), die konfiguriert sind, um ein erstes Prozessgas entlang einer ersten Richtung (X1) für die gesamte zu bearbeitende Fläche vorzusehen, wobei die erste Richtung (X1) parallel zu der zu bearbeitenden Fläche verläuft; und
zwei zweite Gaseinlasskanäle (3), die in Abständen entlang einer zweiten Richtung (X2) angeordnet sind und konfiguriert sind, um ein zweites Prozessgas für zwei Einstellbereiche (61) vorzusehen, die jeweils entlang der ersten Richtung (X1) an Kanten auf beiden Seiten der zu bearbeitenden Fläche angrenzen,
wobei die mehreren ersten Gaseinlasskanäle (2) zwischen den beiden zweiten Gaseinlasskanälen (3) vorgesehen sind; und wobei eine Gesamtverteilungsstrecke der beiden zweiten Gaseinlasskanäle (3) in der zweiten Richtung (X2) größer ist als eine Gesamtverteilungsstrecke der mehreren ersten Gaseinlasskanäle (2) in der zweiten Richtung (X2);
jeder zweite Gaseinlasskanal (3) eine Hilfsgas-Einlassleitung (31) aufweist und die Hilfsgas-Einlassleitung (31) mehrere Auslässe hat; oder jeder zweite Gaseinlasskanal (3) mehrere Hilfsgas-Einlassleitungen (31) aufweist und jede Hilfsgas-Einlassleitung (31) einen einzigen Auslass hat; und
die zweite Richtung (X2) senkrecht zu der ersten Richtung (X1) und parallel zu der zu bearbeitenden Fläche verläuft; und
eine Abgasstruktur (7) an einer Seitenwand der Kammer (4) gegenüber der Gaseinlassstruktur (1) angeordnet ist,
wobei das erste Prozessgas ein Gas für eine Epitaxie-Reaktion enthält, das zweite Prozessgas jedoch kein Gas für die Epitaxie-Reaktion enthält.

2. Epitaxievorrichtung nach Anspruch 1, wobei:
das Verhältnis eines Radius der zu bearbeitenden Fläche zu einer Breite jedes der beiden Einstellbereiche (61) in der zweiten Richtung (X2) größer oder gleich etwa 15 ist.

3. Epitaxievorrichtung nach Anspruch 1, wobei:
die Durchflussrate des ersten Prozessgases, das aus den mehreren ersten Gaseinlasskanälen (2) austritt, gleich der Durchflussrate des zweiten Prozessgases ist, das aus den beiden zweiten Gaseinlasskanälen (3) austritt.

4. Epitaxievorrichtung nach Anspruch 1, wobei:
die mehreren ersten Gaseinlasskanäle (2) gleichmäßig entlang der zweiten Richtung (X2) angeordnet sind.

5. Epitaxievorrichtung nach Anspruch 1, wobei:
die Gesamtverteilungsstrecke (Dg2) der mehreren ersten Gaseinlasskanäle (2) entlang der zweiten Richtung (X2) größer oder gleich einem Durchmesser (Ds) der zu bearbeitenden Fläche ist.

6. Epitaxievorrichtung nach Anspruch 1, wobei:
jeder zweite Gaseinlasskanal (3) mehrere Hilfsgas-Einlassleitungen (31) aufweist und jede Hilfsgas-Einlassleitung (31) einen einzigen Auslass hat;
die mehreren Hilfsgas-Einlassleitungen (31) in einem gleichseitigen Polygon angeordnet sind; und
ein tiefster Punkt des gleichseitigen Polygons und ein tiefster Punkt der mehreren ersten Gaseinlasskanäle (2) in derselben Ebene (P2) liegen.

7. Epitaxievorrichtung nach Anspruch 1, wobei:
das Verhältnis der Gesamtverteilungsstrecke (Dg1) der beiden zweiten Gaseinlasskanäle (3) entlang einer zweiten Richtung (X2) zu einem Durchmesser (Ds) der zu bearbeitenden Fläche zwischen 0,8 und 1,4 liegt.

8. Epitaxievorrichtung nach Anspruch 1, wobei:
jeder erste Gaseinlasskanal (2) von einem benachbarten ersten Gaseinlasskanal (2) mit einem Abstand von etwa 5 mm bis 30 mm angeordnet ist.

9. Epitaxievorrichtung nach Anspruch 1, wobei:
das Verhältnis eines Durchmessers jedes ersten Gaseinlasskanals (2) zu einem Durchmesser jedes zweiten Gaseinlasskanals (3) zwischen 60 und 6 liegt.

10. Epitaxievorrichtung nach Anspruch 1, wobei:
das erste Prozessgas ein Trägergas, das Gas für die Epitaxie-Reaktion und ein Dotiergas aufweist;
das Trägergas mindestens eines von Stickstoff oder Wasserstoff aufweist;
das Gas für die Epitaxie-Reaktion mindestens eines von Silan, Siliciumdichlordihydrogen, Siliciumtrichlorhydrogen oder Siliciumtetrachlorid aufweist; und
das Dotiergas mindestens eines von Phosphin, Diboran oder Arsin aufweist.

11. Epitaxievorrichtung nach Anspruch 1, wobei:
das zweite Prozessgas ein Trägergas aufweist;
das Trägergas mindestens eines von Stickstoff oder Wasserstoff aufweist.

12. Gaseinlassstruktur (1) für eine Epitaxievorrichtung, aufweisend:
mehrere erste Gaseinlasskanäle (2), die konfiguriert sind, um ein erstes Prozessgas entlang einer ersten Richtung (X1) für eine gesamte zu bearbeitende Fläche vorzusehen, wobei die erste Richtung (X1) parallel zu der zu bearbeitenden Fläche verläuft; und
zwei zweite Gaseinlasskanäle (3), die in Abständen entlang einer zweiten Richtung (X2) angeordnet sind und konfiguriert sind, um ein zweites Prozessgas für zwei Einstellbereiche (61) vorzusehen, die jeweils entlang der ersten Richtung (X1) an Kanten auf beiden Seiten der zu bearbeitenden Fläche angrenzen, wobei die mehreren ersten Gaseinlasskanäle (2) zwischen den beiden zweiten Gaseinlasskanälen (3) vorgesehen sind; und eine Gesamtverteilungsstrecke (Dg1) der beiden zweiten Gaseinlasskanäle (3) in der zweiten Richtung (X2) größer ist als eine Gesamtverteilungsstrecke (Dg2) der mehreren ersten Gaseinlasskanäle (2) in der zweiten Richtung (X2);
wobei jeder zweite Gaseinlasskanal (3) eine Hilfsgas-Einlassleitung (31) aufweist und die Hilfsgas-Einlassleitung (31) mehrere Auslässe hat;
oder jeder zweite Gaseinlasskanal (3) mehrere Hilfsgas-Einlassleitungen (31) aufweist und jede Hilfsgas-Einlassleitung (31) einen einzigen Auslass hat; und
die zweite Richtung (X2) senkrecht zu der ersten Richtung (X1) und parallel zu der zu bearbeitenden Fläche verläuft; und
wobei das erste Prozessgas ein Gas für eine Epitaxie-Reaktion enthält, das zweite Prozessgas jedoch kein Gas für die Epitaxie-Reaktion enthält.

13. Gaseinlassstruktur (1) nach Anspruch 12, wobei:
jeder zweite Gaseinlasskanal (3) mehrere Hilfsgas-Einlassleitungen (31) aufweist und jede Hilfsgas-Einlassleitung (31) einen einzigen Auslass hat;
die mehreren Hilfsgas-Einlassleitungen (31) in einem gleichseitigen Polygon angeordnet sind; und
ein tiefster Punkt des gleichseitigen Polygons und ein tiefster Punkt der mehreren ersten Gaseinlasskanäle (2) in derselben Ebene (P2) liegen.

14. Gaseinlassstruktur (1) nach Anspruch 13, wobei:
jeder zweite Gaseinlasskanal (3) drei Hilfsgas-Einlassleitungen (31) aufweist; und
die drei Hilfsgas-Einlassleitungen (31) in einem gleichseitigen Dreieck angeordnet sind.

15. Gaseinlassstruktur (1) nach Anspruch 12, wobei:
das Verhältnis eines Durchmessers jedes ersten Gaseinlasskanals (2) zu einem Durchmesser jedes zweiten Gaseinlasskanals (3) zwischen 60 und 6 liegt.

## Revendications

1. Dispositif épitaxial, comportant :
une chambre (4),
une embase (5) disposée dans la chambre (4) pour porter une pièce à traiter (6),
une structure d'admission de gaz (1) disposée sur une paroi latérale de la chambre (4) pour fournir un gaz de procédé à une surface à traiter de la pièce à traiter (6), la structure d'admission de gaz (1) comprenant :
une pluralité de premiers passages d'admission de gaz (2) configurés pour fournir un premier gaz de procédé à toute la surface à traiter le long d'une première direction (X1), la première direction (X1) étant parallèle à la surface à traiter, et
deux seconds passages d'admission de gaz (3) qui sont agencés à des intervalles le long d'une seconde direction (X2) et configurés pour fournir un second gaz de procédé à deux zones de réglage (61) adjacentes à des bords des deux côtés de la surface à traiter respectivement le long de la première direction (X1), la pluralité de premiers passages d'admission de gaz (2) étant fournie entre les deux seconds passages d'admission de gaz (3), et une distance de répartition totale des deux seconds passages d'admission de gaz (3) dans la seconde direction (X2) est plus grande qu'une distance de répartition totale de la pluralité de premiers passages d'admission de gaz (2) dans la seconde direction (X2),
chaque second passage d'admission de gaz (3) comprend une conduite d'admission de gaz auxiliaire (31), et la conduite d'admission de gaz auxiliaire (31) a une pluralité de sorties, ou chaque second passage d'admission de gaz (3) comprend une pluralité de conduites d'admission de gaz auxiliaires (31), et chaque conduite d'admission de gaz auxiliaire (31) a une sortie unique ; et
la seconde direction (X2) est perpendiculaire à la première direction (X1) et parallèle à la surface à traiter, et
une structure d'évacuation (7) agencée sur une paroi latérale de la chambre (4) à l'opposé de la structure d'admission de gaz (1),
dans lequel le premier gaz de procédé contient un gaz de réaction épitaxiale, le second gaz de procédé ne contenant pas le gaz de réaction épitaxiale.

2. Dispositif épitaxial selon la revendication 1, dans lequel :
un rapport d'un rayon de la surface à traiter sur une largeur de chacune des deux zones de réglage (61) dans la seconde direction (X2) est supérieur ou égal à environ 15.

3. Dispositif épitaxial selon la revendication 1, dans lequel :
un débit du premier gaz de procédé s'écoulant à l'extérieur de la pluralité de premiers passages d'admission de gaz (2) est identique à un débit du second gaz de procédé s'écoulant à l'extérieur des deux seconds passages d'admission de gaz (3).

4. Dispositif épitaxial selon la revendication 1, dans lequel :
la pluralité de premiers passages d'admission de gaz (2) est agencée uniformément le long de la seconde direction (X2).

5. Dispositif épitaxial selon la revendication 1, dans lequel :
une distance de répartition totale (Dg2) de la pluralité de premiers passages d'admission de gaz (2) le long de la seconde direction (X2) est supérieure ou égale à un diamètre (Ds) de la surface à traiter.

6. Dispositif épitaxial selon la revendication 1, dans lequel :
lorsque chaque second passage d'admission de gaz (3) comprend une pluralité de conduites d'admission de gaz auxiliaires (31), et chaque conduite d'admission de gaz auxiliaire (31) a une seule sortie,
la pluralité de conduites d'admission de gaz auxiliaires (31) est disposée dans un polygone équilatéral, et
un point le plus bas du polygone équilatéral et un point le plus bas de la pluralité de premiers passages d'admission de gaz (2) sont dans un même plan (P2).

7. Dispositif épitaxial selon la revendication 1, dans lequel :
un rapport d'une distance de répartition totale (Dg1) des deux seconds passages d'admission de gaz (3) le long d'une seconde direction (X2) sur un diamètre (Ds) de la surface à traiter varie entre 0,8 et 1,4.

8. Dispositif épitaxial selon la revendication 1, dans lequel :
chaque premier passage d'admission de gaz (2) est espacé d'un premier passage d'admission de gaz (2) adjacent d'une distance approximativement comprise entre 5 mm et 30 mm.

9. Dispositif épitaxial selon la revendication 1, dans lequel :
un rapport d'un diamètre de chaque premier passage d'admission de gaz (2) sur un diamètre de chaque second passage d'admission de gaz (3) varie entre 60 et 6.

10. Dispositif épitaxial selon la revendication 1, dans lequel :
le premier gaz de procédé comprend un gaz porteur, le gaz de réaction épitaxiale et un gaz dopant,
le gaz porteur comprend au moins un élément parmi l'azote ou l'hydrogène,
le gaz de réaction épitaxiale comprend au moins un élément parmi du silane, du dichlorodihydrogène de silicium, du trichlorohydrogène de silicium ou du tétrachlorure de silicium, et
le gaz dopant comprend au moins un élément parmi une phosphine, un diborane ou une arsine.

11. Dispositif épitaxial selon la revendication 1, dans lequel :
le second gaz de procédé comprend un gaz porteur,
le gaz porteur comprend au moins un élément parmi l'azote ou l'hydrogène.

12. Structure d'admission de gaz (1) pour un dispositif épitaxial, comportant :
une pluralité de premiers passages d'admission de gaz (2) configurés pour fournir un premier gaz de procédé à toute une surface à traiter le long d'une première direction (X1), la première direction (X1) étant parallèle à la surface à traiter, et
deux seconds passages d'admission de gaz (3) qui sont agencés à des intervalles le long d'une seconde direction (X2) et configurés pour fournir un second gaz de procédé à deux zones de réglage (61) adjacentes à des bords des deux côtés de la surface à traiter respectivement le long de la première direction (X1), la pluralité de premiers passages d'admission de gaz (2) étant fournie entre les deux seconds passages d'admission de gaz (3), et une distance de répartition totale (Dg1) des deux seconds passages d'admission de gaz (3) dans la seconde direction (X2) est plus grande qu'une distance de répartition totale (Dg2) de la pluralité de premiers passages d'admission de gaz (2) dans la seconde direction (X2),
chaque second passage d'admission de gaz (3) comprend une conduite d'admission de gaz auxiliaire (31), et la conduite d'admission de gaz auxiliaire (31) a une pluralité de sorties, ou chaque second passage d'admission de gaz (3) comprend une pluralité de conduites d'admission de gaz auxiliaires (31), et chaque conduite d'admission de gaz auxiliaire (31) a une sortie unique ; et
la seconde direction (X2) est perpendiculaire à la première direction (X1) et parallèle à la surface à traiter, et
dans laquelle le premier gaz de procédé contient un gaz de réaction épitaxiale, le second gaz de procédé ne contenant pas le gaz de réaction épitaxiale.

13. Structure d'admission de gaz (1) selon la revendication 12, dans laquelle :
lorsque chaque second passage d'admission de gaz (3) comprend une pluralité de conduites d'admission de gaz auxiliaires (31), et chaque conduite d'admission de gaz auxiliaire (31) a une seule sortie,
la pluralité de conduites d'admission de gaz auxiliaires (31) est disposée dans un polygone équilatéral, et
un point le plus bas du polygone équilatéral et un point le plus bas de la pluralité de premiers passages d'admission de gaz (2) sont dans un même plan (P2).

14. Structure d'admission de gaz (1) selon la revendication 13, dans laquelle :
chaque second passage d'admission de gaz (3) comprend trois conduites d'admission de gaz auxiliaires (31), et
les trois conduites d'admission de gaz auxiliaires (31) sont agencées dans un triangle équilatéral.

15. Structure d'admission de gaz (1) selon la revendication 12, dans laquelle :
un rapport d'un diamètre de chaque premier passage d'admission de gaz (2) sur un diamètre de chaque second passage d'admission de gaz (3) varie entre 60 et 6.
